# EUROPEAN PATENT APPLICATION

(11) **EP 0 983 843 A2**
(43) Date of publication of application: **08.03.2000**
(21) Application number: 99306622.4
(22) Date of filing: 20.08.1999
(51) Int. Cl.: B32B 18/00

(54) **Low temperature co-fired ceramic**

(30) Priority: 31.08.1998 US 144429
(71) Applicant: CTS Corporation, Elkhart, Indiana 46514-1899 (US)
(72) Inventor: Black, Marc A., St. Joseph, IN 46635 (US); Ernsberger, Craig N., St. Joseph, IN 46530 (US)
(74) Representative: Loven, Keith James

(57) **Abstract**

A multilayered low temperature co-fired ceramic (LTCC) with constraining core has a first and second high shrinkage ceramic layer and a low shrinkage ceramic layer located between the first and second high shrinkage ceramic layers. After firing, the multilayered low temperature ceramic has the dimensions of the low shrinkage ceramic layer in the x and y axes. Circuit interconnects and components such as capacitors, resistors , bond pads, circuit lines and vias are located on each layer. A method of manufacturing is also described.

## Description

### FIELD OF THE INVENTION

This invention generally relates to ceramic electronic packaging. Specifically, there is a multilayered low temperature co-fired ceramic (LTCC) base with a constraining core to minimize shrinkage during firing.

### DESCRIPTION OF THE RELATED ART

Various devices are well known for providing ceramic packages for semiconductor devices and passive components. One of the prior art designs is a low temperature co-fired ceramic (LTCC) substrate. The LTCC ceramic is made of layers of ceramic material, which in an unfired state, are called green tapes. Circuit lines, resistors, capacitors, bonding pads and vias are created on the surface and in holes of the green tapes by conventional thick film screening techniques. The layers are stacked on top of each other laminated and fired at a relatively low temperature in a furnace. During firing, the LTCC shrinks along the x, y and z axes typically 10-20 percent depending upon the LTCC formulation.

Despite the advantages of the prior art LTCC designs, problems occur with the registration or alignment of the circuit lines and components on the various layers of the tapes during manufacturing. Especially, during firing, when the LTCC shrinks, some layers may shrink at different rates than the other layers causing misalignment of the bond pads, vias and other components. These misaligned components can cause connected circuits to have opens or shorts, resulting in a defective part that is non-repairable and has to be discarded.

US - A - 5,518,969 discloses a process for producing low shrink ceramic composition.

### SUMMARY OF THE INVENTION

It is a feature of the invention to provide a low temperature co-fired ceramic (LTCC) with a constraining core.

A further feature of the invention is to provide a low temperature co-fired ceramic including a first and second high shrinkage ceramic layer and a low shrinkage ceramic layer located between the first and second high shrinkage ceramic layers. After firing, the multilayered low temperature ceramic has the dimensions of the low shrinkage ceramic layer in at least two axes.

A further feature of the invention is to provide a multilayered low temperature co-fired ceramic having a first and second low shrinkage ceramic layer. A high shrinkage ceramic layer is located between the first and second low shrinkage ceramic layers such that after firing the multilayered low temperature ceramic has the dimensions of the low shrinkage ceramic layer in at least two axes.

A further feature of the invention is to provide a method of making a multilayered low temperature cofired ceramic with low shrinkage properties after firing by providing a first high shrinkage ceramic layer or layers and then placing a low shrinkage ceramic layer on top of the first high shrinkage ceramic layers. Next, a second high shrinkage ceramic layer or layers is placed on top of the low shrinkage ceramic layer and the first high shrinkage ceramic layer, the low shrinkage ceramic layer and the second high shrinkage ceramic layer are fired in a furnace.

A further feature of the invention is to provide another method of making a multilayered low temperature co-fired ceramic with low shrinkage properties after firing, including providing a first low shrinkage ceramic layer. A high shrinkage ceramic layer is placed on top of the first low shrinkage ceramic layer. A second low shrinkage ceramic layer is placed on top of the high shrinkage ceramic layer and the first low shrinkage ceramic layer, the high shrinkage ceramic layer and the second low shrinkage ceramic layer are fired in a furnace.

Those skilled in the art will appreciate that the conception, upon which this disclosure is based, may readily be utilized as a basis for the designing of other structures, methods and systems for carrying out the several purposes of the present invention.

### BRIEF DESCRIPTION OF THE DRAWINGS

These and other features of the invention can best be understood by the following description of the accompanying drawings as follows:

FIG. 1 is a side cross-sectional view of the preferred embodiment of a low temperature co-fired ceramic (LTCC) with a constraining core.

FIG. 2 is a side cross-sectional view of another embodiment of an LTCC with a constraining core.

It is noted that the drawings of the invention are not to scale. The drawings are merely schematic representations, not intended to portray specific parameters of the invention. The drawings are intended to depict only typical embodiments of the invention, and therefore should not be considered as limiting the scope of the invention. The invention will be described with additional specificity and detail through the accompanying drawings.

### DETAILED DESCRIPTION OF THE PREFERRED EMBODIMENTS

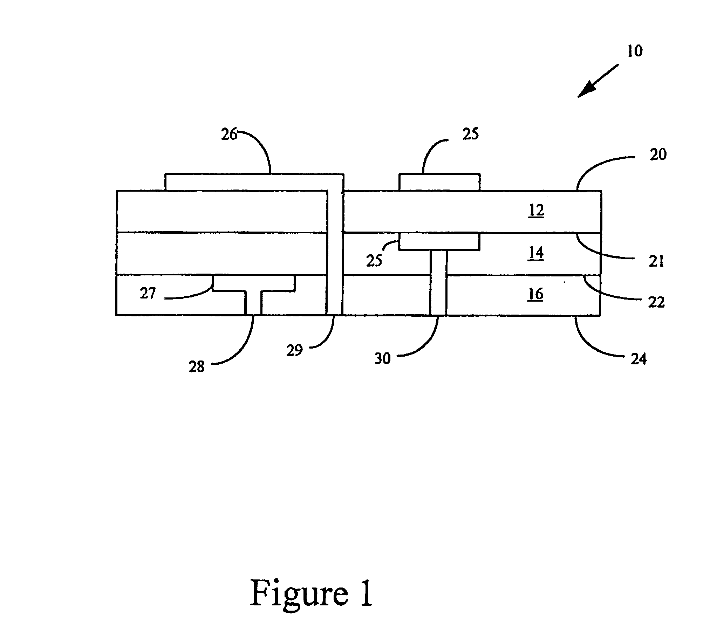

Referring to Figure 1, a side cross-sectional view of the preferred embodiment of a multilayered low temperature co-fired ceramic (LTCC) with constraining core assembly 10 is shown. A pair of planar high shrinkage layers 12 and 16 have a planar low shrinkage or high compaction material layer 14 located therebetween. The high shrinkage layers 12 and 16 are conventional LTCC tapes. An example of layers 12 and 16 is 951 Green Tape (tm) commercially available from Dupont Corporation, Electronic Materials Division, Wilmington, Delaware. An example of a low shrinkage material layer, 14 is a LTCC tape available from Ragan Technologies Inc., San Diego, California, under the brand name ZST. High shrinkage layers 12 and 16, by themselves, shrink from 8 to 12 percent during firing in all axes. Low shrinkage layer 14, by itself, shrinks .5 to 1.5 percent during firing in all axes.

The combination of the low shrinkage layer 14 between the high shrinkage layers 12 and 16 causes a change in the shrinkage rate of the overall assembly 10 during firing. The high shrinkage layers 12 and 16 shrink only .8 to 1.2 percent in the x and y axes during firing. This is the same rate as low shrinkage material 14. High shrinkage layers 12 and 16 do not shrink at their normal 10 to 12 percent rate in the z-axis. The high shrinkage layers 12 and 16 shrink at a much higher rate in the z-axis of 40 to 60 percent in order to arrive at a normal density after firing. Layers 12 and 16 shrink as to conserve mass. The high shrinkage layers 12 and 16 shrink during firing to maintain a normal fired density of greater than 90 percent of the theoretical fully compacted density. Low shrinkage material 14 shrinks at normal shrinkage rates of.8 to 1.2 percent in the x, y and z axes. The low shrinkage layer 14 is not fully dense and has some residual porosity. After firing, the low shrinkage layer 14 ends up with high porosity and the high shrinkage layers 12 and 16 have a low porosity. The low shrinkage layer 14 constrains the shrinkage of high shrinkage layers 12 and 16 to that of low shrinkage layer 14 in the x and y directions. The resulting assembly 10 after firing is able to better hold registration and tolerances for circuit components placed on layers 12, 14 and 16. The better registration results in improved yields, better quality, less rejects, less scrap and lower costs of manufacturing.

Various circuit features and passive electronic components can be included in assembly 10 if desired. An electrode 25 is located on surface 20 of layer 12. Another electrode is located on surface 21 of layer 12. Electrodes 25 form a capacitor. A via 30 connects buried electrode 25 to outer surface 24. A circuit line 26 is located on surface 20. A via 29 connects an end of circuit line 26 to bottom side 24 of layer 16. A buried resistor 27 is shown on surface 22 of layer 14. A via 28 connects resistor 27 with bottom side 24 of layer 16. These are some examples of the circuit features and components that can be fabricated on assembly 10. Electrodes 25, resistor 27, circuit line 28 and vias 28, 29, and 30 are made from conventional thick film conductor materials and are applied by conventional thick film screening and curing techniques. Circuit lines 26 and vias 28, 29 and 30 connect with other circuit lines (not shown) or components (not shown) on the LTCC device 10. These circuit features and components have to be held to precise registration and tolerances in order for them to properly connect during the firing process. In the case of a misalignment among the circuit components, an open or a short may result.

LTCC assembly 10, of Figure 1 can be assembled as follows: The first step is to punch vias 28, 29, 30 into layers 12,14 and 16. The vias are then screen filled with a conductive material on each of layers 12, 14, and 16. Next, electrodes 25, resistors 27 and circuit lines 26 would be screened onto sides 21, 22, 23 or 24 of layers 12, 14 or 16. Low shrinkage ceramic layer 14 is placed on top of the second high shrinkage ceramic layer 16. Next, the first high shrinkage ceramic layer 12 is placed on top of the low shrinkage ceramic layer 14 and laminated under heat and pressure. The assembly 10 is fired in a furnace at 850 degrees centigrade.

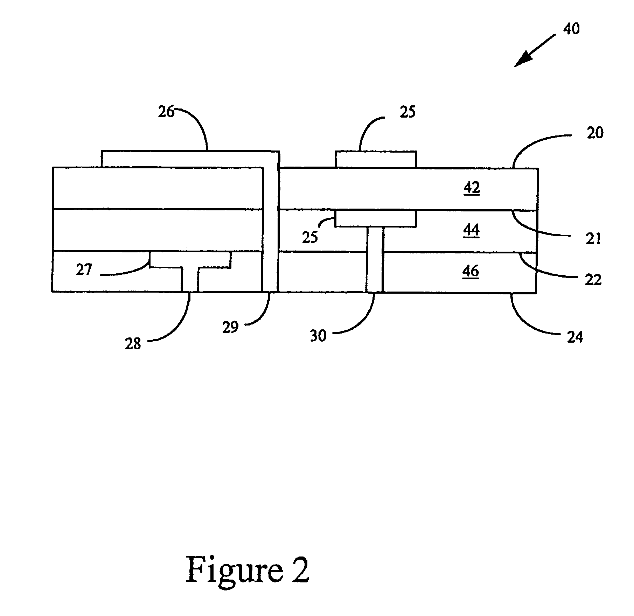

Referring to Figure 2, a side cross-sectional view of another embodiment of an LTCC with constraining core assembly 40 is shown. A pair of planar low shrinkage material layers 42 and 46 has a planar high shrinkage material layer 44 located therebetween. High shrinkage layer 44 is a conventional LTCC tape commercially available from Dupont Corporation, Electronic Materials Division, Wilmington, Delaware under the brand name 951 green tape. The low shrinkage material layers, 42 and 46 are a LTCC tape available from Ragan Technologies Inc., San Diego, California, under the brand name ZST. As in Figure 1, the high shrinkage layer 44 shrinks from 8 to 12 percent during firing in all axes. Low shrinkage layers 42 and 46 shrink .5 to 1.5 percent during firing in all axes.

Again, similar to Figure 1, the combination of low shrinkage layers 42 and 46 between high shrinkage layers 44 causes a change in the shrinkage rate of the overall assembly 40 during firing. High shrinkage layer 44 shrinks .8 to 1.2 percent in the x and y axes during firing. This is the same rate as low shrinkage materials 42 and 46. High shrinkage layer 44 does not shrink at the normal 10 to 12 percent rate in the z-axis. Layer 44 shrinks at a much higher rate in the z-axis in order to arrive at a normal density after firing. Layer 44 shrinks as to conserve mass. The high shrinkage layer 44 shrinks during firing to maintain a normal fired density of greater than 90 percent of the theoretical fully compacted density. Low shrinkage layers 42 and 46 shrink at normal shrinkage rates of.8 to 1.2 percent in the x, y and z axes. The low shrinkage layers 42 and 46 are not fully dense and have some residual porosity. After firing, the low shrinkage layers 42 and 46 have high porosity and the high shrinkage layer 44 has a low porosity. Low shrinkage layers 42 and 46 constrain the shrinkage of high shrinkage layer 44 to that of low shrinkage layers 42 and 46 in the x and y directions. The resulting assembly 40 after firing is able to better hold registration and tolerances for circuit components placed on layers 42, 44 and 46. The better registration results in improved yields, better quality, less rejects, less scrap and lower costs of manufacturing.

Again similarly to Figure 1, various circuit features and passive electronic components can be included in assembly 40 if desired. An electrode 25 is located on surface 20 of layer 42. Another electrode is located on surface 21 of layer 42. Electrodes 25 form a capacitor. A via 30 connects buried electrode 25 to outer surface 24. A circuit line 26 is located on surface 20. A via 29 connects an end of circuit line 26 to bottom side 24 of layer 46. A buried resistor 27 is shown on surface 22 of layer 44. A via 28 connects resistor 27 with bottom side 24 of layer 46. These are some examples of the circuit features and components that can be fabricated on assembly 40. Electrodes 25, resistor 27, circuit line 26 and vias 28, 29, and 30 are made from conventional thick film conductor materials and are applied by conventional thick film screening and curing techniques. Circuit lines 26 and vias 28, 29 and 30 connect with other circuit lines (not shown) or components (not shown) on LTCC device 40. These circuit features and components have to be held to precise registration and tolerances in order for them to properly connect during the firing process. In the case of a misalignment among the circuit components, an open or a short may result.

LTCC assembly 40, of Figure 2 can be assembled as follows: The first step is to punch vias 28, 29, 30 into layers 12, 14 and 16. The vias are then screen filled with a conductive material on each of layers 12, 14, and 16. Next, electrodes 25, resistors 27 and circuit lines 26 would be screened onto sides 21, 22, 23 or 24 of layers 12, 14 or 16. High shrinkage ceramic layer 44 is placed on top of second low shrinkage ceramic layer 46. Next, the first low shrinkage ceramic layer 42 is placed on top of the high shrinkage ceramic layer 44 and laminated under heat and pressure. The assembly 40 is fired in a furnace at 900 degrees centigrade.

### VARIATIONS OF THE PREFERRED EMBODIMENTS

One of ordinary skill in the arts electronic packaging and electronic ceramics, will realize many advantages from using the preferred embodiment. Further, one of ordinary skill in the art will realize that there are many different ways of accomplishing the preferred embodiment. For example, it is contemplated that more high shrinkage layers 12 and 16 could be stacked on low shrinkage layer 14. Similarly, more low shrinkage layers 42 and 46 could be stacked on high shrinkage layer 44. It is possible to stack several units of assembly 10 or 40 on each other and then fire the overall unit.

The embodiment shows the use of vias 28, 29 and 30 to make electrical connections. Other electrical connections could be used such as pressed in pins.

Even though the embodiment discusses the use of low temperature co-fired ceramics, other ceramics could be used such as high temperature ceramics.

Even though the embodiment discusses the use of low and high shrinkage rate ceramic layers, ceramics with other rates of shrinkage could be used.

While the invention has been taught with specific reference to these embodiments, someone skilled in the art will recognize that changes can be made in form and detail without departing from the scope of the invention. The described embodiments are to be considered in all respects only as illustrative and not restrictive.

## Claims

1. A multilayered low temperature co-fired ceramic, comprising a core layer located between a pair of outer layers, wherein either the core layer is a low shrinkage ceramic layer and the outer layers are high shrinkage ceramic layers, or the core layer is a high shrinkage ceramic layer and the outer layers are low shrinkage ceramic layers, and wherein, after firing, the multilayered low temperature ceramic has the dimensions of the low shrinkage ceramic layer or layers in at least two axes.

2. A multilayered low temperature co-fired ceramic according to Claim 1, wherein at least one circuit line is disposed on an outer surface thereof.

3. A multilayered low temperature cofired ceramic according to Claim 1 or 2, wherein at least one circuit line is disposed on a surface of the core layer.

4. A multilayered low temperature co-fired ceramic according to Claim 1, 2 or 3, wherein at least one resistor is disposed on an outer surface thereof.

5. A multilayered low temperature cofired ceramic according to any preceding claim, wherein at least one resistor is disposed on a surface of the core layer.

6. A multilayered low temperature co-fired ceramic according to any preceding claim, wherein a conductive via extends through a first of the outer layers.

7. A multilayered low temperature cofired ceramic according to any preceding claim, wherein a conductive via extends through a first of the outer layers and through the core layer.

8. A multilayered low temperature cofired ceramic according to any preceding claim, wherein a conductive via extends through both the outer layers and through the core layer.

9. A multilayered low temperature co-fired ceramic according to any preceding claim, wherein the or each low shrinkage ceramic layer shrinks from -1% to 2.0% during firing.

10. A multilayered low temperature co-fired ceramic according to any preceding claim, wherein the or each high shrinkage layer shrinks so as to conserve mass in a z axis and from -1 % to 2.0% in x and y axes.

11. A multilayered low temperature co-fired ceramic according to any preceding claim, further including at least one capacitor disposed therein.

12. A method of making a multilayered low temperature co-fired ceramic with low shrinkage properties after firing, comprising forming a structure having a core layer located between a pair of outer layers, wherein either the core layer is a low shrinkage ceramic layer and the outer layers are high shrinkage ceramic layers, or the core layer is a high shrinkage ceramic layer and the outer layers are low shrinkage ceramic layers, and firing the structure in a furnace.

13. A method according to Claim 11, further including placing resistors, capacitors, circuit lines and vias on the multilayered low temperature co-fired ceramic.

14. A method according to Claim 11 or 12, wherein the firing temperature is between 700 and 900 degrees Celsius.
